# FASCICULE DE BREVET EUROPEEN

(11) **EP 1 208 589 B1**
(45) Date de publication et mention de la délivrance du brevet: **22.12.2010**
(21) Numéro de dépôt: 00958696.7
(22) Date de dépôt: 17.08.2000
(51) Int. Cl.: H01L 21/324, H01L 21/306, H01L 21/762, H01L 21/18

(54) **PROCEDE DE TRAITEMENT DE SUBSTRATS POUR LA MICRO-ELECTRONIQUE**
VERFAHREN ZUR BEHANDLUNG VON MIKROELEKTRONIKSUBSTRATEN
METHOD FOR TREATING SUBSTRATES FOR MICROELECTRONICS

(30) Priorité: 20.08.1999 FR 9910667
(43) Date de publication de la demande: 29.05.2002
(73) Titulaire: S.O.I.Tec Silicon on Insulator Technologies, 38190 Bernin (FR)
(72) Inventeur: BARGE, Thierry, F-38000 Grenoble (FR); AUBERTON-HERVE, André, F-38240 Meylan (FR); AGA, Hiroji, Annaka Gunma 379-0127 (JP); TATE, Naoto, Annaka Gunma 379-0111 (JP)
(74) Mandataire: Texier, Christian
(86) Numéro de dépôt international: PCT/FR2000/002330
(87) Numéro de publication internationale: WO 2001/015215

(56) Documents cités:
- EP-A- 0 917 188
- EP-A- 0 917 193
- FR-A- 2 761 526
- FR-A- 2 777 115
- US-A- 5 589 422
- MORICEAU H ET AL: "HYDROGEN ANNEALING TREATMENT USED TO OBTAIN HIGH QUALITY SOI SURFACES" ANNUAL IEEE INTERNATIONAL SILICON-ON-INSULATOR CONFERENCE,US,NEW YORK, NY: IEEE, vol. CONF. 24, 1998, pages 37-38, XP000830634 ISBN: 0-7803-4501-0
- SATO N ET AL: "Hydrogen annealed silicon-on-insulator" APPLIED PHYSICS LETTERS,US,AMERICAN INSTITUTE OF PHYSICS. NEW YORK, vol. 65, no. 15, 10 octobre 1994 (1994-10-10), pages 1924-1926-1926, XP002101679 ISSN: 0003-6951
- W.P. MASZARA ET AL.: "Quality of SOI film after surface smoothing with hydrogen annealing, touch polishing." PROCEEDINGS OF THE 1997 IEEE INTERNATIONAL SOI CONFERENCE, octobre 1997 (1997-10), pages 130-131, XP000801874 NEW YORK

## Description

L'invention concerne le domaine des procédés de traitement de substrats destinés à la fabrication de composants pour la micro-électronique et/ou pour l'opto-électronique.

L'invention porte également sur les substrats obtenus par ce procédé.

Plus précisément, l'invention concerne le domaine des procédés de traitement de substrats entièrement semi-conducteurs (par exemple de silicium) ou entièrement isolants, ou bien encore constitués d'un empilement de couches semi-conductrices ou isolantes. Il peut s'agir de substrats sur lesquels est déposée une couche (par exemple épitaxiale) ou encore de substrats comprenant des structures non homogènes, tels que des substrats comprenant des composants ou des parties de composants à des niveaux plus ou moins avancés de leur élaboration.

Il existe sur une certaine profondeur à partir de la surface d'au moins une face de ces substrats, une couche de matériau entrant, au moins en partie, dans la constitution des composants réalisés sur cette face. Pour la suite, cette couche sera désignée par l'expression "couche utile".

La qualité de cette couche utile conditionne celle des composants. Des recherches sont constamment effectuées pour améliorer la qualité de cette couche utile. Ainsi, on cherche aussi bien à diminuer la rugosité de surface de cette couche utile, qu'à réduire la concentration de défauts dans l'épaisseur de celle-ci.

Il est connu que l'on peut utiliser des méthodes de polissage mécano-chimique pour réduire la rugosité de surface de la couche utile.

Il est aussi connu que l'on peut utiliser des techniques de polissage mécano-chimique pour réduire la concentration de certains défauts dans la couche utile, lorsqu'il existe un gradient de concentration de ces défauts, croissant en direction de la surface de celle-ci. Dans ce cas, le polissage mécano-chimique permet d'abraser la couche utile jusqu'aux zones, situées en profondeur par rapport à la surface initiale de la couche utile, présentant une concentration de ces défauts acceptable.

Cependant, il est aussi connu que le polissage mécano-chimique engendre une dégradation de certaines propriétés de la couche utile et une diminution de la capacité de production de substrats ( FR 2 762 136 et FR 2 761 526).

Il a alors été proposé de remplacer le polissage mécano-chimique, en particulier lorsque la couche utile est constituée de silicium, par un recuit dans une atmosphère hydrogénée (FR 2 762 136, FR 2 761 526 et « Hydrogen Annealing Treatment Used to Obtain High Quality SOI Surfaces », Annual IEEE International Silicon-On-Insulator Conference, US, New-York (NY), IEEE vo. Conf. 24, 1998, pages 37, 28)). Un recuit sous atmosphère hydrogénée, de substrats comprenant une couche utile constituée de silicium, a un effet de réduction de la rugosité de surface, en particulier par reconstruction de la surface de silicium, ainsi qu'un rôle de guérison de certains défauts cristallins.

On connaît également par Le document EP-A-0 917 188 un procédé comprenant en succession un polissage suivi d'un recuit sous atmosphère réductrice.

On connaît enfin par le document US-A-5 589 422 un procédé constitué par une succession d'oxydations sacrificielles, permettant de garder un environnement gazeux et un budget thermique limité.

Un but de l'invention est d'améliorer encore la qualité de la couche utile par un nouveau séquencement d'étapes.

Ce but est atteint, selon l'invention, grâce à un procédé de traitement tel que défini dans la revendication 1.

Il est bien connu que le polissage mécano-chimique engendre certains défauts dans le matériau sous-jacent à la surface polie et est susceptible de provoquer des inhomogénéités d'épaisseur des substrats, et de la couche utile en particulier.

Cependant, et de manière surprenante, le déposant a pu constater qu'en faisant précéder l'étape de polissage mécano-chimique, par un recuit sous atmosphère réductrice, on pouvait à la fois améliorer la qualité de la couche utile de manière plus efficace qu'avec un simple polissage ou un simple recuit, mais aussi que l'on évitait en grande partie les effets néfastes d'un simple polissage mécano-chimique. En effet, le recuit sous atmosphère réductrice a déjà commencé à lisser la surface de la couche utile. Le temps de polissage nécessaire pour obtenir une rugosité satisfaisante est donc réduit. De ce fait, le procédé selon l'invention permet d'augmenter les capacités de production. En outre, la réduction du temps de polissage limite les effets négatifs du polissage, tels que ceux cités ci-dessus, ou encore la perte d'uniformité d'épaisseur qui intervient généralement lorsque le polissage est long.

Ainsi, la qualité, en termes de rugosité de la couche utile, après mise en oeuvre du procédé selon l'invention, est particulièrement intéressante.

Les mesures de la rugosité sont généralement effectuées grâce à un microscope à force atomique. Avec ce type d'appareil, la rugosité est mesurée sur des surfaces balayées par la pointe du microscope à force atomique, allant de 1x1 µm² à 10x10 µm² et plus rarement 50x50 µm², voire 100x100 µm². La rugosité peut être caractérisée, en particulier, selon deux modalités. Selon l'une de ces modalités, la rugosité est dite à hautes fréquences et correspond à des surfaces balayées de l'ordre de 1 x1 µm². Selon l'autre de ces modalités, la rugosité est dite à basses fréquences et correspond à des surfaces balayées de l'ordre de 10x10 µm², ou plus.

Un polissage mécano-chimique et un recuit sous atmosphère réductrice se distinguent par leurs effets sur des plages de fréquences différentes. Ainsi, un recuit sous atmosphère réductrice favorise un lissage de la rugosité à hautes fréquences, mais est moins efficace pour réduire les ondulations, qui sont plutôt de basses fréquences. Tandis qu'un polissage mécano-chimique permet aussi d'améliorer la rugosité à basses fréquences.

Grâce au procédé selon l'invention, on peut obtenir une faible rugosité à hautes fréquences, grâce au recuit sous atmosphère réductrice, ainsi que de faibles ondulations, c'est à dire un type de rugosité à basses fréquences, grâce au polissage. Or, une faible rugosité à hautes fréquences est primordiale pour obtenir de bons oxydes de grille, et une faible ondulation (rugosité à basses fréquences) est intéressante lorsque l'on souhaite coller un autre substrat sur la surface libre de la couche utile.

En plus de son effet sur la rugosité, le procédé selon l'invention permet de réduire la concentration de certains défauts dans la couche utile. En effet, le recuit sous atmosphère réductrice permet de commencer à reconstruire la surface de la couche utile et de guérir certains défauts dans l'épaisseur de la couche utile. Cependant, cette guérison peut n'être que partielle. Mais, le polissage mécano-chimique, si on le poursuit suffisamment, permet un enlèvement de la matière comportant une grande partie des défauts situés au voisinage de la surface libre de la couche utile et dans l'épaisseur de cette couche utile. Le procédé selon l'invention est donc particulièrement avantageux, lorsqu'il existe un gradient de concentration croissant en direction de la surface libre de la couche utile, et une forte concentration de défauts au voisinage de cette surface. L'effet combiné de la guérison des défauts, par le recuit sous atmosphère réductrice, et de l'enlèvement de matière, par le polissage, permet de retirer particulièrement efficacement les défauts au voisinage de la surface libre de la couche utile.

Grâce au procédé selon l'invention, on obtient donc un substrat avec une couche utile dont la qualité est suffisante et compatible avec l'utilisation de cette couche utile dans des applications en micro- ou opto-électronique.

Avantageusement, l'atmosphère réductrice comprend de l'hydrogène. Préférentiellement, cette l'atmosphère réductrice comprend en outre de l'argon.

Ainsi, l'atmosphère réductrice peut être composée d'hydrogène à 100%. Mais avantageusement, l'atmosphère réductrice est composée d'un mélange d'hydrogène et d'argon. Ce mélange est préférentiellement dans un rapport H₂/Ar de 20/80 ou de 25/75. Avec des rapports de ce type, l'hydrogène est en concentration suffisante pour être significative, mais grâce à l'argon, le mélange est meilleur conducteur thermique. L'amélioration des propriétés de conduction thermique du mélange permet de réduire les contraintes thermiques sur le substrat. Il en résulte une plus faible génération de défauts de type bandes de glissement. Ce type de mélange est également moins agressif, il en résulte une attaque moins sélective de certains défauts.

Avantageusement aussi, le procédé selon l'invention comporte en outre, une étape d'oxydation sacrificielle. Cette étape d'oxydation sacrificielle comporte une étape d'oxydation de la couche utile sur au moins une partie de son épaisseur et une étape de désoxydation de cette partie oxydée. Les étapes d'oxydation et de désoxydation peuvent être menées subséquemment à l'étape de polissage et/ou précédemment à celle-ci.

Une étape d'oxydation sacrificielle est avantageusement mise en oeuvre pour améliorer la qualité d'une couche utile, que le matériau constitutif de cette couche utile soit un matériau facilement oxydable ou un matériau peu oxydable. Dans la suite, et en particulier dans les revendications, on considérera une étape d'oxydation sacrificielle réalisable, que le matériau de la couche utile soit facilement oxydable ou peu oxydable.

Chacune des étapes de polissage et d'oxydation sacrificielle participe au retrait de la partie de la couche utile comportant une concentration de défauts trop importante. Mais une étape d'oxydation sacrificielle, subséquente à l'étape de polissage, participe plus spécifiquement à la suppression des défauts superficiels générés par l'étape de polissage.

Une étape d'oxydation sacrificielle permet en outre de limiter d'autres effets néfastes du polissage. En effet, si l'on part d'une couche de défauts relativement épaisse, il faut un long polissage pour l'ôter. Or un long polissage abouti généralement à un manque d'uniformité en épaisseur. Cet inconvénient est d'autant plus critique que l'épaisseur de matériau à enlever est importante et donc que l'étape de polissage est longue. De plus, de longs polissages ralentissent l'exécution du procédé et induisent une limitation à la capacité de production. En introduisant une étape d'oxydation sacrificielle dans le procédé selon l'invention, on évite ces inconvénients en limitant le polissage essentiellement à ce qui est nécessaire pour réduire la rugosité, l'étape d'oxydation sacrificielle contribuant de manière non négligeable à retirer la partie de la couche utile comportant une forte concentration de défauts. De plus en réduisant le polissage nécessaire, les défauts engendrés par celui-ci peuvent être développés à moins grande échelle.

Avantageusement encore, le procédé selon l'invention comporte au moins une étape de traitement thermique, l'étape d'oxydation de la couche utile étant réalisée avant la fin de chacune de ces étapes de traitement thermique, pour protéger le reste de la couche utile. Dans ces conditions, le traitement thermique permet aussi de guérir, au moins en partie, les défauts générés au cours de l'étape d'oxydation.

Avantageusement encore, le procédé selon l'invention comporte en outre une étape de recuit sous atmosphère réductrice subséquente à l'étape de polissage.

Avantageusement encore, le procédé selon l'invention comprend une étape d'implantation d'atomes sous une face d'une plaque, dans une zone d'implantation, une étape de mise en contact intime de la face de la plaque, ayant subi l'implantation, avec un substrat support et une étape de clivage de la plaque au niveau de la zone d'implantation, pour transférer une partie de la plaque sur le substrat support et former un film mince ou une couche mince sur celui-ci, ce film mince ou cette couche mince, constituant la couche utile subissant ensuite les étapes de recuit hydrogéné et de polissage.

Avantageusement encore, le procédé selon l'invention est mis en oeuvre sur un substrat comportant une couche utile constituée d'un matériau semi-conducteur. Ce matériau semi-conducteur est par exemple du silicium.

Avantageusement encore, et en particulier si la couche utile est constituée par du silicium, l'étape de recuit sous atmosphère réductrice, est réalisée, suivant un mode opératoire connu et décrit par exemple dans le document FR 2 761 526. Selon ce mode opératoire, on recuit le substrat à une température comprise entre environ 1050°C et 1350°C, pendant quelques dizaines de secondes à quelques dizaines de minutes, sous une atmosphère hydrogénée.

Suivant une autre variante avantageuse du procédé selon l'invention, l'étape de recuit sous atmosphère réductrice, est réalisée, suivant un autre mode opératoire connu et décrit par exemple dans le document EP 917 188. Selon cet autre mode opératoire, on recuit le substrat, sous atmosphère hydrogénée, à une température comprise entre environ 1100°C et 1300°C, pendant moins de trois minutes, préférentiellement en moins de 60 secondes et plus préférentiellement encore pendant moins de trente secondes. Cet autre mode opératoire correspond à un recuit rapide, aussi appelé recuit RTA (RTA étant l'acronyme de l'expression anglo-saxonne Rapid Thermal Annealing).

Le recuit peut être effectué à température constante, à température variable, avec des paliers de température, ou une combinaison de paliers et de plages variables.

Suivant encore une autre variante avantageuse du procédé selon l'invention, l'étape de recuit sous atmosphère réductrice, est réalisée, suivant un autre mode opératoire connu et décrit par exemple dans le document FR 2 761 526. Selon cet autre mode opératoire, on recuit le substrat dans un appareil produisant un plasma d'hydrogène. L'avantage de ce type de recuit réside dans le fait que la température de recuit est basse. Typiquement, cette température est située dans une plage allant de la température ambiante à 600°C environ.

Avec une couche utile constituée de silicium, que l'étape de recuit sous atmosphère hydrogénée soit effectuée selon un recuit long, un recuit dans un plasma d'hydrogène ou qu'elle le soit selon un recuit de type RTA, elle a plusieurs effets. Ces effets sont :
- une désintégration de l'oxyde natif en surface de la couche utile ;
- une gravure du silicium (SiH₂ et SiH₄ étant volatils) menant à une réduction de l'épaisseur moyenne de la couche utile ;
- une guérison de certains défauts par dissolution des précipités d'oxygène et autres parois d'oxydes, susceptibles de jouer un rôle stabilisant sur certains défauts cristallins ; mais aussi
- un lissage et une diminution de la rugosité de la surface de la couche utile, avec apparition de terrasses à l'échelle atomique.

En particulier, la désintégration des oxydes de silicium par l'hydrogène facilite grandement la réorganisation des atomes de silicium.

En surface en particulier, les atomes de silicium, activés par le recuit sous atmosphère hydrogénée, migrent en surface jusqu'à ce qu'ils se trouvent dans une configuration énergétique correspondant à une stabilité accrue. Ainsi les atomes de silicium se trouvant sur des excroissances tendent à migrer dans des cavités. C'est ainsi que l'étape de recuit sous atmosphère hydrogénée tend à réduire la rugosité de surface.

En ce qui concerne la guérison de certains défauts, l'effet de dissolution des précipités d'oxygène et autres parois d'oxyde, est particulièrement intéressant dans le cas des défauts appelés « COPs » (de l'acronyme de l'expression anglo-saxonne Crystal Originated Particles). Ces défauts « COPs » sont des amas de lacunes, dont la taille est de l'ordre de quelques centaines à quelques milliers d'angströms et dont les parois orientées, selon des plans cristallins, sont stabilisées par des oxydes dont l'épaisseur est de l'orde de quelques dizaines d'angströms au maximum. Ces défauts « COPs » apparaissent en particulier dans le silicium CZ.

Selon un autre aspect, l'invention est un substrat pour la micro-électronique ou l'opto-électronique, comportant une couche utile sur au moins une de ses faces, ce substrat ayant été obtenu après une étape de polissage mécano-chimique sur la surface libre de la couche utile, caractérisé en ce qu'il a subi en outre, une étape de recuit sous atmosphère réductrice, avant l'étape de polissage.

D'autres aspects, buts et avantages de l'invention apparaîtront à la lecture de la description détaillée qui suit. L'invention sera aussi mieux comprise à l'aide des dessins annexés sur lesquels :
- la figure 1 représente schématiquement, en coupe longitudinale, un exemple de chambre pour effectuer chaque étape de recuit en atmosphère hydrogénée, du procédé selon l'invention ;
- la figure 2 représente schématiquement, en coupe selon un plan perpendiculaire à ses surfaces principales, un substrat au cours de son traitement par le procédé conforme à la présente invention ;
- la figure 3 représente schématiquement, en coupe selon un plan perpendiculaire à ses surfaces principales, un substrat au cours de son traitement par une variante du procédé conforme à la présente invention ;
- la figure 4 représente schématiquement, en coupe selon un plan perpendiculaire à ses surfaces principales, un substrat au cours de son traitement par une autre variante du procédé conforme à la présente invention ;
- la figure 5 représente schématiquement, en coupe selon un plan perpendiculaire à ses surfaces principales, un substrat au cours de son traitement par encore une autre variante du procédé conforme à la présente invention ; et
- la figure 6 représente schématiquement, en coupe selon un plan perpendiculaire à ses surfaces principales, un substrat au cours de son traitement par encore une autre variante du procédé conforme à la présente invention.

Cinq modes de mise en oeuvre du procédé conforme à la présente invention sont décrits ci-dessous, à titre d'exemples, de manière détaillée.

Ces cinq modes de mise en oeuvre sont illustrés ci-dessous, à titre d'exemple, mais sans que cela soit limitatif, dans le cadre de la fabrication de substrats de silicium sur isolant. Les substrats de silicium sur isolant sont aussi appelés substrats SOI (SOI étant l'acronyme de l'expression anglo-saxonne « Silicon On Insulator »).

Dans ce cadre, le procédé selon l'invention trouve une application particulièrement intéressante, dans la fabrication de substrats SOI par un type particulier de procédés, appelés procédés SMART-CUT^{®}.

Une manière particulière de mettre en oeuvre un procédé SMART-CUT^{®} est décrite dans le brevet FR 2 681 472.

Dans le cadre de la fabrication de substrats SOI, un procédé SMART-CUT^{®} permet de réaliser des substrats comportant une couche utile 52 constituée de silicium sur une de leur face, cette couche de silicium reposant sur une couche d'isolant, aussi appelée couche d'oxyde enterré 56.

Selon l'une de ses variantes, le procédé SMART-CUT^{®} comporte:
- une étape d'implantation d'atomes, sous une face d'une plaque de semi-conducteur, dans une zone d'implantation ;
- une étape de mise en contact intime de la plaque soumise à l'implantation, avec un substrat support; et
- une étape de clivage de la plaque au niveau de la zone d'implantation, pour transférer la partie de la plaque située entre la surface soumise à l'implantation et la zone d'implantation, sur ledit substrat support et former un film mince, ou une couche, de silicium sur celui-ci.

Par implantation d'atomes, on entend tout bombardement d'espèces atomiques ou ioniques, susceptible d'introduire ces espèces dans un matériau, avec un maximum de concentration de ces espèces dans ce matériau, ce maximum étant situé à une profondeur déterminée par rapport à la surface bombardée. Les espèces atomiques ou ioniques sont introduites dans le matériau avec une énergie également distribuée autour d'un maximum. L'implantation des espèces atomiques dans le matériau peut être réalisée grâce à un implanteur par faisceau d'ions, un implanteur par immersion dans un plasma, etc.

Par clivage, on entend toute fracture du matériau implanté au niveau du maximum de concentration, dans ce matériau, des espèces implantées ou au voisinage de ce maximum. Cette fracture n'intervient pas nécessairement selon un plan cristallographique du matériau implanté.

Plusieurs manières peuvent être envisagées pour réaliser un substrat SOI, selon le procédé SMART-CUT^{®}.

Selon une première manière, on recouvre une plaque de silicium sur sa face d'implantation, d'une couche d'oxyde isolant (par exemple par oxydation du silicium), et on utilise un substrat support, par exemple aussi en silicium, pour le transfert.

Selon une deuxième manière, on transfère une couche complètement semi-conductrice (en silicium), soit sur un substrat support recouvert d'une couche d'isolant, soit sur un substrat support complètement isolant (par exemple en quartz).

Selon une troisième manière, on transfère une couche recouverte d'une couche d'isolant, soit sur un substrat support recouvert également d'isolant, soit sur un substrat support complètement isolant.

Après clivage et transfert, on obtient dans tous les cas, un substrat 50 SOI avec une couche transférée sur une face du substrat support, la surface libre de cette couche correspondant à une surface de clivage. Après clivage, le substrat 50 est dépoussiéré, nettoyé et rincé selon les techniques habituelles utilisées en micro-électronique.

Il est alors avantageux d'utiliser le procédé selon l'invention, pour réduire la rugosité de ladite surface libre et la densité de défauts dans la couche transférée.

Selon le procédé conforme à la présente invention, le substrat 50 SOI subit une étape de recuit sous atmosphère réductrice 100 et une étape de polissage 200.

Pour tous les modes de mise en oeuvre décrits ci-dessous, l'étape de recuit sous atmosphère réductrice est réalisée selon le mode opératoire RTA décrit ci-dessus.

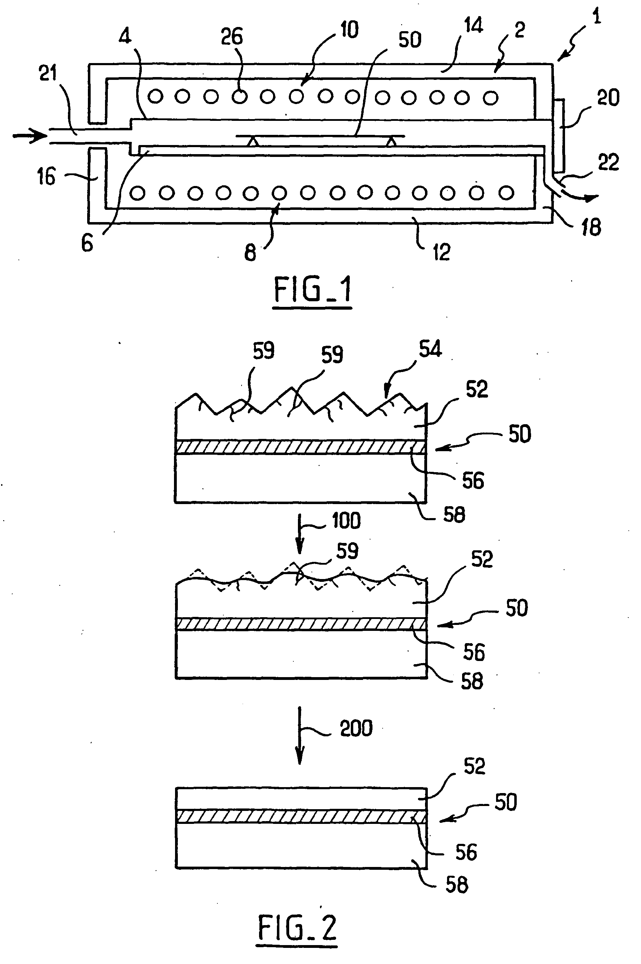

Un exemple de chambre destinée à la mise en oeuvre d'une étape de recuit sous atmosphère réductrice 100, selon le mode opératoire RTA, est illustré par la figure 1.

Cette chambre 1 comporte une enceinte 2, un réacteur 4, un plateau porte-substrat 6, deux réseaux de lampes halogène 8, 10 et deux paires de lampes latérales.

L'enceinte 2 comporte en particulier une paroi inférieure 12, une paroi supérieure 14 et deux parois latérales 16, 18, situées respectivement aux extrémités longitudinales de l'enceinte 2. L'une des parois latérales 16, 18 comporte une porte 20.

Le réacteur 4 est constitué d'un tube de quartz s'étendant longitudinalement entre les deux parois latérales 16, 18. Il est muni au niveau de chacune de ces parois latérales 16, 18, respectivement d'une entrée de gaz 21 et d'une sortie de gaz 22. La sortie de gaz 22 est située du coté de la paroi latérale 18 comportant la porte 20.

Chaque réseau de lampes halogène 8, 10 est situé respectivement au-dessus et en-dessous du réacteur 4, entre celui-ci et les parois inférieure 12 et supérieure 14. Chaque réseau de lampes halogène 8, 10 comporte 17 lampes 26 disposées perpendiculairement à l'axe longitudinal du réacteur 4. Les deux paires de lampes latérales (non représentées sur la figure 1) sont situées parallèlement à l'axe longitudinal du réacteur 4, chacune d'un côté de celui-ci, globalement aux extrémités longitudinales des lampes 26 des réseaux de lampes halogène 8, 10.

Le plateau porte-substrat 6 coulisse dans le réacteur 4. Il supporte les substrats 50 destinés à subir l'étape de recuit sous atmosphère hydrogénée 100 et permet de les rentrer ou les sortir de la chambre 1.

Une chambre 1 de ce type est commercialisée par STEAG^{®}, sous le nom « SHS AST 2800 ».

Les cinq modes de mise en oeuvre du procédé selon l'invention, décrits ci-dessous, sont appliqués au traitement de substrats 50 SOI comportant une couche utile 52 ayant elle même une surface libre 54. Cette surface libre 54 est une surface de clivage obtenue, comme décrit ci-dessus, par la mise en oeuvre d'un procédé SMART-CUT^{®}. Sous la couche utile 52, le substrat 50 comporte une couche d'oxyde enterré 56. Sous la couche d'oxyde enterré 56, le substrat 50 comporte un substrat support 58.

Les paramètres donnés pour les cinq modes de mise en oeuvre du procédé selon l'invention, qui vont être décrits ci-dessous, correspondent à des applications dites « produits fins ». Ces « produits fins » sont des substrats SOI dont la couche de silicium sur isolant, c'est à dire la couche utile 52, fait environ 2000 Å d'épaisseur, tandis que la couche d'isolant enterré 56, fait environ 4000 Å d'épaisseur. Pour réaliser des substrats SOI ayant une couche utile 52 et/ou une couche d'oxyde enterré plus épaisse(s), on procédera à une implantation à plus haute énergie, pour que la couche d'espèces atomiques implantées soit située plus profondément par rapport à la surface bombardée. Dans ce cas il faudra aussi tenir compte du fait que plus les espèces atomiques sont implantées profond, plus il sera nécessaire de retirer de la matière après clivage, pour retrouver une concentration de défauts dans la couche utile 52, acceptable. En effet, plus les espèces atomiques sont implantées profondément, plus la largeur de la zone défectueuse augmente.

Selon le premier mode de mise en oeuvre, représenté sur la figure 2, un substrat 50 est soumis, après l'étape de clivage du procédé SMART-CUT^{®} décrit ci-dessus et un nettoyage, à une étape de recuit sous atmosphère réductrice 100, puis à une étape de polissage mécano-chimique 200.

Avant ces deux étapes, la concentration de défauts 59 de la couche utile 52, au voisinage de la surface libre 54, et la rugosité de cette dernière ne sont pas satisfaisantes.

L'étape de recuit sous atmosphère réductrice 100 est réalisée selon le mode opératoire du type RTA décrit plus haut.

L'étape de recuit sous atmosphère réductrice consiste à :
- disposer le substrat 50 dans une chambre 1 telle que celle décrite ci-dessus, celle-ci étant froide au moment de l'introduction du substrat 50 ;
- introduire, à une pression égale à, ou voisine de, la pression atmosphérique, un mélange d'hydrogène et d'argon, dans des proportions en volume de 25% d'hydrogène pour 75% d'argon ;
- faire croître, en allumant les lampes halogène 26, la température dans la chambre 1, à une vitesse de l'ordre de 50°C par seconde, jusqu'à une température de traitement ;
- maintenir le substrat 50 dans la chambre 1, pendant 20 secondes, à la température de traitement, cette température de traitement étant avantageusement choisie entre 1200 et 1230 °C, et étant préférentiellement égale à 1230°C ; et
- éteindre les lampes halogène 26 et refroidir, par circulation d'air, le substrat 50, à une vitesse de plusieurs dizaines de degrés centigrades par secondes et variant selon la gamme de température.

Dans ces conditions, avec des rampes de chauffage et de refroidissement rapides, et un palier court, ce recuit sous atmosphère réductrice 100 a réduit la rugosité, sans pratiquement retirer de matière. L'épaisseur de matériau retirée est inférieure à 20 Å. La réduction de la rugosité a été essentiellement réalisée par reconstruction de surface et lissage et non pas par gravure. En outre, les défauts 59 cristallins du silicium de la couche utile 52, générés au cours de l'implantation et du clivage, ont au moins en partie été guéris par ce recuit sous atmosphère réductrice 100. La concentration de ces défauts 59, dans la couche utile 52, a donc diminué. En conséquence, l'épaisseur de couche utile 52, sur laquelle la concentration de défauts 59 est trop importante pour être acceptable, est réduite. De plus, le fait d'opérer ce recuit sous atmosphère réductrice 100, selon le mode opératoire RTA, permet d'éviter la propagation de l'attaque de certains défauts jusqu'à la couche d'oxyde enterré 56.

L'étape de recuit sous atmosphère réductrice 100 décrite ci-dessus offre de nombreux autres avantages. Elle est facilement compatible avec une grande capacité de production de substrats 50, est d'utilisation aisée, peut être mise en oeuvre avec des équipements déjà existants, etc.

La rugosité est généralement exprimée soit en terme d'écart entre la hauteur minimum et la hauteur maximum mesurée au cours du balayage de la surface dont la rugosité est mesurée, soit par une valeur quadratique moyenne, dite rms (de l'expression anglo-saxonne « root mean square »). L'écart entre hauteurs minimum et maximum sera désignée ci-dessous par « P-V » (de l'expression anglo-saxonne « Peak-Valley »).

Après l'étape de recuit sous atmosphère réductrice 100, la rugosité mesurée lors d'un balayage d'une surface de 1x1 µm², est réduite de 50 à 1-1,5 Å rms (c'est à dire d'une valeur supérieure à 500 Å à 20 Å environ, en valeur P-V), et la rugosité mesurée lors d'un balayage d'une surface de 10x10 µm², est réduite de 50 à 5-15 Å rms (c'est à dire d'une valeur supérieure à 500 Å à 40-50 Å en valeur P-V).

L'étape de polissage 200 est réalisée par un polissage mécano-chimique classique, connu de l'homme du métier. Partant d'une surface déjà bien lissée par l'étape de recuit sous atmosphère réductrice 100, une étape de polissage 200 sur une épaisseur de 200 à 400 Å seulement, est suffisante pour ramener la rugosité, et plus particulièrement celle à basses fréquences, à une valeur satisfaisante. Typiquement, la rugosité après polissage est de l'ordre de 0,8 à 1,5 Å rms, si cette mesure est réalisée au cours du balayage d'une surface de 1x1 µm² ou de l'ordre de 1 à 2 Å rms, si cette mesure est réalisée au cours du balayage d'une surface de 10x10 µm².

Cette étape de polissage 200 permet en outre de retirer la matière de la couche utile 52, située à proximité de la surface libre 54 et comportant des défauts 59.

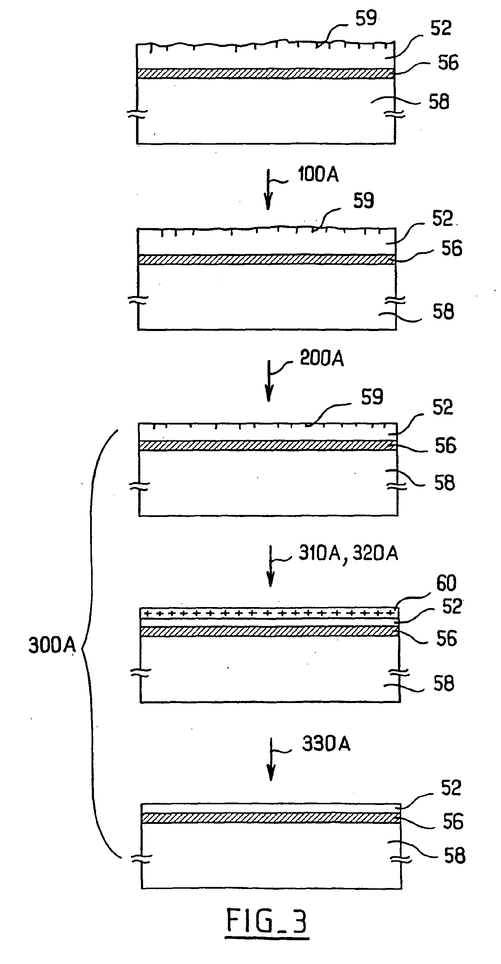

Le deuxième mode de mise en oeuvre du procédé selon l'invention est représenté sur la figure 3. A titre d'exemple, comme précédemment, il est réalisé sur un substrat 50 de type SOI obtenu après l'étape de clivage du procédé SMART-CUT^{®} décrit ci-dessus et un nettoyage.

Selon ce deuxième mode de mise en oeuvre, le substrat 50 est soumis à une étape de recuit sous atmosphère réductrice 100A, puis à une étape de polissage mécano-chimique 200A, et enfin à une étape d'oxydation sacrificielle 300A combinée à un traitement thermique 320A.

Les étapes de recuit sous atmosphère réductrice 100A et de polissage mécano-chimique 200A de ce mode de mise en oeuvre sont identiques à celles décrites pour le premier mode de mise en oeuvre.

L'étape d'oxydation sacrificielle 300A est destinée à retirer les défauts 59 restant après l'étape de polissage 200A. Ces défauts 59 peuvent provenir de l'implantation, du clivage, ou avoir été générés pendant l'étape de polissage 200A, etc.

L'étape d'oxydation sacrificielle 300A se décompose en une étape d'oxydation 310A et une étape de désoxydation 330A. Le traitement thermique 320A est intercalé entre l'étape d'oxydation 310A et l'étape de désoxydation 330A.

L'étape d'oxydation 310A est préférentiellement réalisée à une température comprise entre 700°C et 1100°C. L'étape d'oxydation 310A peut être réalisée par voie sèche ou par voie humide. Par voie sèche, l'étape d'oxydation 310A est, par exemple, menée en chauffant le substrat 50 sous oxygène gazeux. Par voie humide, l'étape d'oxydation 310A est, par exemple, menée en chauffant le substrat 50 dans une atmosphère chargée en vapeur d'eau. Par voie sèche ou par voie humide, selon des procédés classiques connus de l'homme du métier, l'atmosphère d'oxydation peut aussi être chargée en acide chlorhydrique.

L'étape d'oxydation 310A aboutit à la formation d'un oxyde 60.

L'étape de traitement thermique 320A est réalisée par toute opération thermique destinée à améliorer les qualités du matériau constitutif de la couche utile 52. Ce traitement thermique 320A peut être effectué à température constante ou à température variable. Dans ce dernier cas, le traitement thermique 320A est réalisé, par exemple, avec une augmentation progressive de la température entre deux valeurs, ou avec une oscillation cyclique entre deux valeurs, etc.

Préférentiellement, l'étape de traitement thermique 320A est effectuée au moins en partie à une température supérieure à 1000°C, et plus particulièrement vers 1100-1200°C.

Préférentiellement, l'étape de traitement thermique 320A est effectuée sous atmosphère non oxydante. L'atmosphère du traitement thermique 320A peut comprendre de l'argon, de l'azote, de l'hydrogène, etc., ou encore un mélange de ces gaz. Le traitement thermique 320A peut également être réalisé sous vide.

Préférentiellement aussi, l'étape d'oxydation 310A est réalisée avant l'étape de traitement thermique 320A. De cette manière, l'oxyde 60 protège le reste de la couche utile pendant le traitement thermique 320A et évite le phénomène de piquage. Le phénomène de piquage est bien connu de l'homme du métier qui le nomme aussi « pitting ». Il se produit à la surface de certains semi-conducteurs lorsque ceux-ci sont recuits sous atmosphère non oxydante, telle que l'azote, l'argon, sous vide, etc. Il se produit dans le cas du silicium en particulier lorsque celui-ci est à nu, c'est à dire lorsqu'il n'est pas du tout recouvert d'oxyde.

Selon une variante avantageuse, l'étape d'oxydation 310A débute avec le début de la montée en température du traitement thermique 320A et se termine avant la fin de ce dernier.

Le traitement thermique 320A permet de guérir, au moins en partie, les défauts générés au cours des étapes précédentes du procédé de fabrication et de traitement du substrat 50. Plus particulièrement, le traitement thermique 320A peut être effectué pendant une durée et à une température telles que l'on réalise par celui-ci une guérison de défauts cristallins, tels que des fautes d'empilement, des défauts « HF », etc., engendrés dans la couche utile 52, au cours de l'étape d'oxydation 310A. On appelle défaut « HF », un défaut dont la présence est révélée par une auréole de décoration dans l'oxyde enterré 56, après traitement du substrat 50 dans un bain d'acide fluorhydrique.

Le traitement thermique 320A présente en outre l'avantage de renforcer l'interface de collage, par exemple entre la couche transférée lors du transfert par le procédé SMART-CUT^{®} et le substrat support 58.

L'étape de désoxydation 330A est préférentiellement réalisée en solution. Cette solution est par exemple une solution d'acide fluorhydrique à 10 ou 20%. Quelques minutes suffisent pour enlever mille à quelques milliers d'angströms d'oxyde 60, en plongeant le substrat 50 dans une telle solution.

Au cours de ce deuxième mode de mise en oeuvre du procédé selon l'invention, on retirera :
- moins de 15 Å de silicium sur la couche utile 52, au cours de l'étape de recuit sous atmosphère réductrice 100,
- 300 Å de silicium sur la couche utile 52, au cours de l'étape de polissage 200, et
- 650 Å de silicium sur la couche utile 52, au cours de l'étape d'oxydation sacrificielle 300.

L'épaisseur totale de couche utile 52, retirée au cours du procédé selon l'invention, dans ce deuxième mode de mise en oeuvre, est égale à 950 Å environ. D'une manière générale, le deuxième mode de mise en oeuvre du procédé selon l'invention permettra avantageusement de retirer 800 à 1100 Å.

Le tableau 1 regroupe les rugosités mesurées à l'issu des différentes étapes du deuxième mode de mise en oeuvre du procédé selon l'invention.

**Tableau 1 : Rugosités mesurées à l'issue des différentes étapes du deuxième mode de mise en oeuvre du procédé selon l'invention.**

| | Surface balayée 1x1 µm² | | Surface balayée 10.x10 µm² | |
|---|---|---|---|---|
| | Rugosité P-V (Å) | Rugosité rms (Å) | Rugosité P-V (Å) | Rugosité rms (Å) |
| Après clivage | 500/1000* | 50/100* | 500/1000* | 50/100* |
| Après l'étape de recuit sous atmosphère réductrice 100 | 10/30 | 1-1,5 | 40-50 | 5-15 |
| Après l'étape de polissage 200 | 10 | 0,8-1,5 | 10 | 1-2 |
| Après l'étape d'oxydation sacrificielle 300 | 10 | 0,8-1,5 | 10 | 1-2 |

| | | | | |
|---|---|---|---|---|
| * : Après clivage, la surface est tellement rugueuse que la rugosité ne peut être mesurée, de manière significative au microscope à force atomique. | | | | |

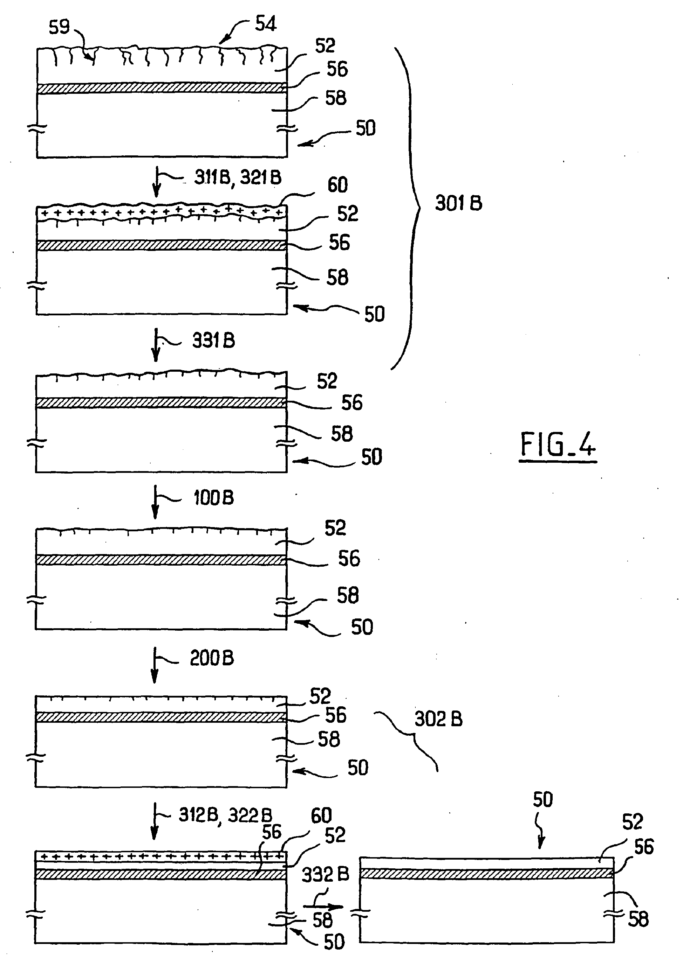

Le troisième mode de mise en oeuvre du procédé selon l'invention est représenté sur la figure 4. A titre d'exemple, et comme pour les modes de mise en oeuvre précédents, il est réalisé sur un substrat 50 de type SOI obtenu après l'étape de clivage du procédé SMART-CUT^{®} décrit ci-dessus et un nettoyage.

Après l'étape de clivage et un nettoyage, le substrat 50 est soumis à :
- une première étape d'oxydation sacrificielle 301B combinée à un traitement thermique 321B,
- une étape de recuit sous atmosphère réductrice 100B,
- une étape de polissage mécano-chimique 200B, et
- une deuxième étape d'oxydation sacrificielle 302B combinée à un traitement thermique 322B.

Les étapes de recuit sous atmosphère réductrice 100B et de polissage mécano-chimique 200B de ce mode de mise en oeuvre sont identiques à celles décrites pour le premier mode de mise en oeuvre décrit ci-dessus.

Les première et deuxième étapes d'oxydation sacrificielle 301B, 302B, se décomposent, comme l'étape d'oxydation sacrificielle 300A décrite ci-dessus, en une étape d'oxydation 311B, 312B et une étape de désoxydation 331B, 332B. Les première et deuxième étapes d'oxydation sacrificielle 301B, 302B, ainsi que les étapes de traitement thermique 321B, 322B, sont analogues à celles déjà décrites pour le deuxième mode de mise en oeuvre, décrit ci-dessus, du procédé conforme à la présente invention.

Au cours de ce troisième mode de mise en oeuvre du procédé selon l'invention, on retirera :
- 650 Å de silicium sur la couche utile 52, au cours de la première étape d'oxydation sacrificielle 301B,
- moins de 15 Å de silicium sur la couche utile 52, au cours de l'étape de recuit sous atmosphère réductrice 100B,
- 300 Å de silicium sur la couche utile 52, au cours de l'étape de polissage 200B, et
- 650 Å de silicium sur la couche utile 52, au cours de la deuxième étape d'oxydation sacrificielle 302B.

L'épaisseur totale de couche utile, retirée au cours du procédé selon l'invention, dans ce troisième mode de mise en oeuvre, est égale à 1600 Å environ.

Le tableau 2 regroupe les rugosités mesurées à l'issu des différentes étapes du deuxième mode de mise en oeuvre du procédé selon l'invention.

**Tableau 2 : Rugosités mesurées à l'issue des différentes étapes du troisième mode de mise en oeuvre du procédé selon l'invention.**

| | Surface balayée 1x1 µm² | | Surface balayée 10x10 µm² | |
|---|---|---|---|---|
| | Rugosité P-V (Å) | Rugosité rms (Å) | Rugosité P-V (Å) | Rugosité rms (Å) |
| Après clivage | 500-1000* | 50-100* | 500-1000* | 50-100* |
| Après la première étape d'oxydation sacrificielle 301 B | 250-500 | 25-50 | 300-600 | 30-60 |
| Après l'étape de recuit sous atmosphère réductrice 100B | 20 | 1-1,5 | 40-50 | 5-10 |
| Après l'étape de polissage 200B | 10 | 0,8-1,5 | 10 | 1-2 |
| Après la deuxième étape d'oxydation sacrificielle 302B | 10 | 0,8-1,5 | 10 | 1-2 |

| | | | | |
|---|---|---|---|---|
| * : Après clivage, la surface est tellement rugueuse que la rugosité ne peut être mesurée, de manière significative au microscope à force atomique. | | | | |

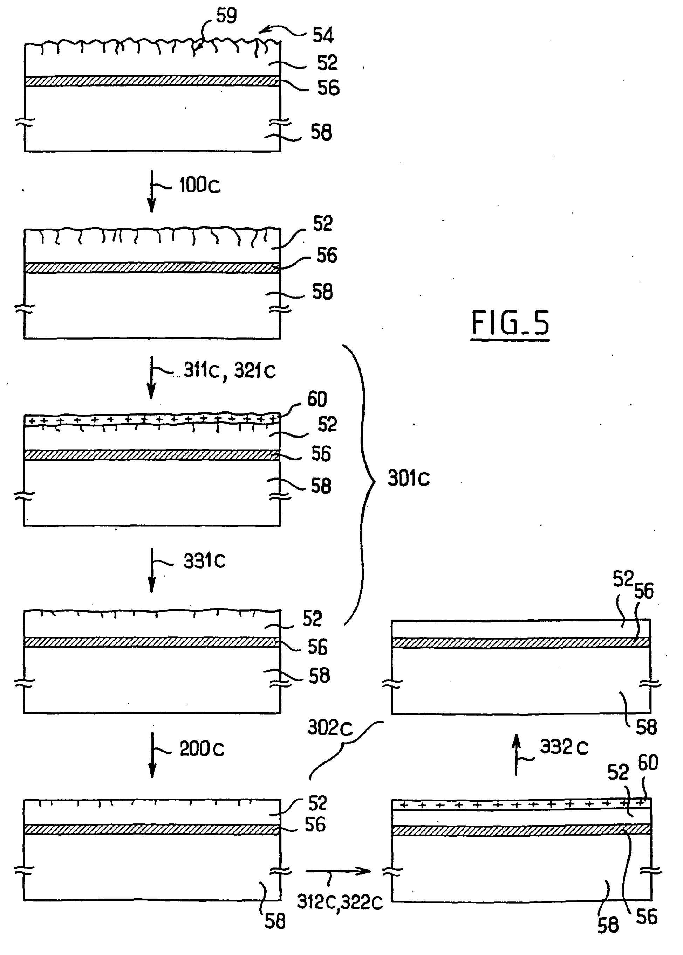

Le quatrième mode de mise en oeuvre est représenté sur la figure 5. A titre d'exemple, et comme pour les modes de mise en oeuvre précédents, il est réalisé sur un substrat 50 de type SOI obtenu après l'étape de clivage du procédé SMART-CUT^{®} décrit ci-dessus.

Après l'étape de clivage et un nettoyage, le substrat 50 est soumis à :
- une étape de recuit sous atmosphère réductrice 100C,
- une première étape d'oxydation sacrificielle 301C combinée à un traitement thermique 321C,
- une étape de polissage mécano-chimique 200C, et
- une deuxième étape d'oxydation sacrificielle 302C combinée à un traitement thermique 322C.

Les étapes de recuit sous atmosphère réductrice 100C et de polissage mécano-chimique 200C de ce mode de mise en oeuvre sont identiques à celles décrites pour le premier mode de mise en oeuvre décrit ci-dessus.

Les première et deuxième étapes d'oxydation sacrificielle 301C, 302C, se décomposent, comme l'étape d'oxydation sacrificielle 300A décrite ci-dessus, en une étape d'oxydation 311C, 312C et une étape de désoxydation 331C, 332C.

Les première et deuxième étapes d'oxydation sacrificielle 301C, 302C, ainsi que les étapes de traitement thermique 321C, 322C, sont analogues à celles déjà décrites pour le deuxième mode de mise en oeuvre, décrit ci-dessus, du procédé conforme à la présente invention.

Au cours de ce quatrième mode de mise en oeuvre du procédé selon l'invention, on retirera :
- moins de 15 Å de silicium sur la couche utile 52, au cours de l'étape de recuit sous atmosphère réductrice 100C,
- 650 Å de silicium sur la couche utile 52, au cours de la première étape d'oxydation sacrificielle 301C,
- 300 Å de silicium sur la couche utile 52, au cours de l'étape de polissage 200C, et
- 650 Å de silicium sur la couche utile 52, au cours de la deuxième étape d'oxydation sacrificielle 302C.

L'épaisseur totale de couche utile 52, retirée au cours du procédé selon l'invention, dans ce quatrième mode de mise en oeuvre, est égale à 1600 Å environ.

Le tableau 3 regroupe les rugosités mesurées à l'issu des différentes étapes du quatrième mode de mise en oeuvre du procédé selon l'invention.

**Tableau 3 : Rugosités mesurées à l'issue des différentes étapes du quatrième mode de mise en oeuvre du procédé selon l'invention.**

| | Surface balayée 1x1 µm² | | Surface balayée 10x10 µm² | |
|---|---|---|---|---|
| | Rugosité P-V (Å) | Rugosité rms (Å) | Rugosité P-V (Å) | Rugosité rms (Å) |
| Après clivage | 500-1000* | 50-100* | 500-1000* | 50-100* |
| Après l'étape de recuit sous atmosphère réductrice 100C | 10-30 | 1-1,5 | 40-50 | 5-15 |
| Après la première étape d'oxydation sacrificielle 301C | 10-30 | 1-1,5 | 40-50 | 5-15 |
| Après l'étape de polissage 200C | 10 | 0,8-1,5 | 10 | 1-2 |
| Après la deuxième étape d'oxydation sacrificielle 302C | 10 | 0,8-1,5 | 10 | 1-2 |

| | | | | |
|---|---|---|---|---|
| * : Après clivage, la surface est tellement rugueuse que la rugosité ne peut être mesurée, de manière significative au microscope à force atomique. | | | | |

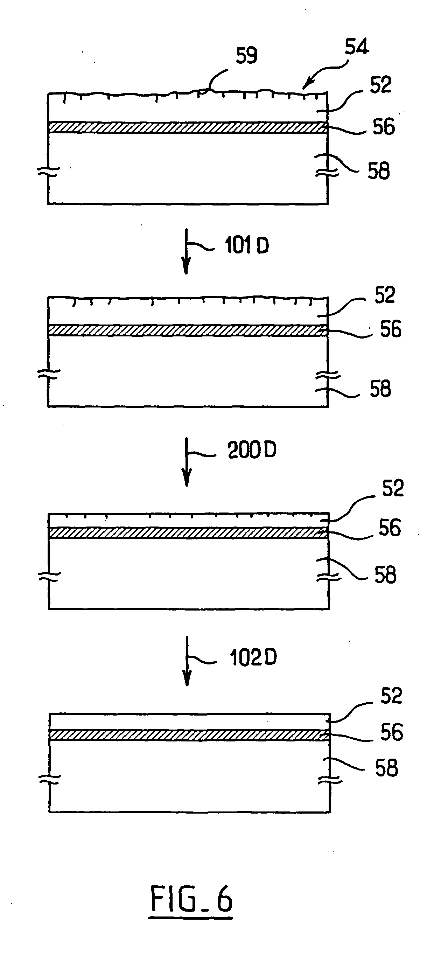

Le cinquième mode de mise en oeuvre est représenté sur la figure 6. A titre d'exemple, et comme pour les modes de mise en oeuvre précédents, il est réalisé sur un substrat 50 de type SOI obtenu après l'étape de clivage du procédé SMART-CUT^{®} décrit ci-dessus.

Après l'étape de clivage et un nettoyage, le substrat 50 est soumis à :
- une première étape de recuit sous atmosphère réductrice 101D,
- une étape de polissage mécano-chimique 200D, et
- une deuxième étape de recuit sous atmosphère réductrice 102D.

Les étapes de recuit sous atmosphère réductrice 101D, 102D et de polissage mécano-chimique 200D de ce mode de mise en oeuvre sont identiques à celles décrites pour le premier mode de mise en oeuvre.

Au cours de ce cinquième mode de mise en oeuvre du procédé selon l'invention, on retirera :
- moins de 15 Å de silicium sur la couche utile 52, au cours de la première étape de recuit sous atmosphère réductrice 101D,
- 400 Å de silicium sur la couche utile 52, au cours de l'étape de polissage 200D, et
- moins de 15 Å de silicium sur la couche utile 52, au cours de la deuxième étape de recuit sous atmosphère réductrice 102D,

L'épaisseur totale de couche utile 52, retirée au cours du procédé selon l'invention, dans ce cinquième mode de mise en oeuvre, est égale à 400Å environ.

Suivant une variante de ce cinquième mode de mise en oeuvre du procédé selon l'invention, il peut être intercalé, dans le cinquième mode de mise en oeuvre décrit ci-dessus, un traitement thermique tel que ceux déjà décrits ou encore une oxydation sacrificielle combinée avec un traitement thermique, telle que celles également décrites ci-dessus.

Le tableau 4 regroupe les rugosités mesurées à l'issu des différentes étapes du cinquième mode de mise en oeuvre du procédé selon l'invention.

**Tableau 4 : Rugosités mesurées à l'issue des différentes étapes du cinquième mode de mise en oeuvre du procédé selon l'invention.**

| | Surface balayée 1x1 µm² | | Surface balayée 10x10 µm² | |
|---|---|---|---|---|
| | Rugosité P-V (Å) | Rugosité rms (Å) | Rugosité P-V (Å) | Rugosité rms (Å) |
| Après clivage | 500-1000* | 50-100* | 500-1000* | 50-100* |
| Après la première étape de recuit sous atmosphère réductrice 101D | 10-30 | 1-1,5 | 40-50 | 5-15 |
| Après l'étape de polissage 200D | 10 | 0,8-1,5 | 10 | 1-2 |
| Après la deuxième étape de recuit sous atmosphère réductrice 102D | 10 | 0,8-1,5 | 10 | 1-2 |

| | | | | |
|---|---|---|---|---|
| * : Après clivage, la surface est tellement rugueuse que la rugosité ne peut être mesurée, de manière significative au microscope à force atomique. | | | | |

Ce cinquième mode de mise en oeuvre du procédé selon l'invention est particulièrement intéressant lorsque la rugosité de surface après clivage est réduite. C'est le cas notamment lorsque l'on a réalisé l'implantation avec plusieurs énergies (FR 2 774 510) et/ou avec plusieurs espèces atomiques ou bien encore lorsque le clivage est assisté par des contraintes mécaniques (FR 2 748 851).

## Revendications

1. Procédé de traitement de substrats (50) pour la micro-électronique ou l'opto-électronique, comportant sur au moins une de leurs faces une couche utile (52) dans laquelle des composants sont destinés à être formés, ce procédé comprenant une étape de polissage mécano-chimique sur la surface libre (54) de la couche utile (52), **caractérisé en ce qu'**il comprend en outre, une étape de recuit sous atmosphère réductrice (100, 100A, 100B, 100C, 101D, 102D), avant l'étape de polissage (200, 200A, 200B, 200C, 200D).

2. Procédé selon la revendication 1, **caractérisé en ce que** l'étape de recuit sous atmosphère réductrice est réalisée en moins de trois minutes, préférentiellement en moins de soixante secondes et plus préférentiellement encore en moins de trente secondes.

3. Procédé selon l'une des revendications précédentes, **caractérisé en ce que** l'étape de recuit sous atmosphère réductrice est réalisée à une température comprise entre 1100° C et 1300°C, et préférentiellement entre 1200°C et 1230°C.

4. Procédé selon l'une des revendications précédentes, **caractérisé en ce qu'**il comporte en outre, subséquemment à l'étape de polissage (200, 200A, 2008, 200C, 200D), une étape d'oxydation (310A, 312B, 312C) de la couche utile (52) sur au moins une partie de son épaisseur.

5. Procédé selon l'une des revendications précédentes, **caractérisé en ce qu'**il comporte en outre, précédemment à l'étape de polissage (200, 200A, 200B, 200C, 200D), une étape d'oxydation (311B, 311C) de la couche utile (52) sur au moins une partie de son épaisseur.

6. Procédé selon l'une des revendications 4 et 5, **caractérisé en ce qu'**il comporte en outre au moins une étape (330A, 331B, 332B, 331C, 332C) d'enlèvement de l'oxyde produit à ladite étape d'oxydation.

7. Procédé selon l'une des revendications 4 à 6, **caractérisé en ce qu'**il comprend en outre au moins une étape de traitement thermique (320A, 321B, 322B, 321C, 322C), l'étape d'oxydation de la couche utile (52) étant réalisée avant la fin de chaque étape de traitement thermique (320A ,321B, 322B, 321C, 322C), pour protéger le reste de la couche utile (52).

8. Procédé selon l'une des revendications précédentes, **caractérisé en ce qu'**il comporte en outre une étape de recuit sous atmosphère réductrice (102D) subséquente à l'étape de polissage (200, 200A, 200B, 200C, 200D).

9. Procédé selon l'une des revendications précédentes, **caractérisé en ce qu'**il comprend une étape d'implantation d'atomes sous une face d'une plaque, dans une zone d'implantation, une étape de mise en contact intime de la face de la plaque, ayant subi l'implantation avec un substrat support et une étape de clivage de la plaque au niveau de la zone d'implantation, pour transférer une partie de la plaque sur le substrat support et former un film mince ou une couche mince sur celui-ci, ce film mince ou cette couche mince, constituant la couche utile (52) subissant ensuite les étapes de recuit sous atmosphère réductrice (100, 100A, 100B, 100C, 101D, 102D) et de polissage (200, 200A, 200B, 200C, 200D).

10. Procédé selon l'une des revendications précédentes, **caractérisé en ce que** la couche utile (52) est constituée d'un semi-conducteur.

11. Procédé selon la revendication 10, **caractérisé en ce que** le semi-conducteur est du silicium.

12. Procédé selon l'une des revendications précédentes, **caractérisé en que** l'atmosphère réductrice comprend de l'hydrogène.

13. Procédé selon l'une des revendications précédentes, **caractérisé en que** l'atmosphère réductrice comprend de l'argon.

## Claims

1. Process for treating substrates (50) for the microelectronics or optoelectronics industry, comprising on at least one of their faces a working layer (52) in which components are intended to be formed, this process comprising a step of chemical-mechanical polishing on the free surface (54) of the working layer (52), **characterized in that** it also comprises a step of annealing under a reductive atmosphere (100, 100A, 100B, 100C, 101D, 102D), before the polishing step (200, 200A, 200B, 200C, 200D).

2. Process according to Claim 1, **characterized in that** the step of annealing under a reductive atmosphere is carried out in less than three minutes, preferably in less than sixty seconds and even more preferably in less than thirty seconds.

3. Process according to either of the preceding claims, **characterized in that** the step of annealing under a reductive atmosphere is carried out at a temperature of between 1100°C and 1300°C, and preferably between 1200°C and 1230°C.

4. Process according to one of the preceding claims, **characterized in that** it also comprises, after the polishing step (200, 200A, 200B, 200C, 200D), a step (310A, 312B, 312C) of oxidizing the working layer (52) over at least a portion of its thickness.

5. Process according to one of the preceding claims, **characterized in that** it also comprises, before the polishing step (200, 200A, 200B, 200C, 200D), a step (311B, 311C) of oxidizing the working layer (52) over at least a portion of its thickness.

6. Process according to either of Claims 4 and 5, **characterized in that** it also comprises at least one step (330A, 331B, 332B, 331C, 332C) of removing the oxide produced in said oxidation step.

7. Process according to one of claims 4 to 6, **characterized in that** it also comprises at least one heat treatment step (320A, 321B, 322B, 321C, 322C), the step of oxidizing the working layer (52) being carried out before the end of each heat treatment step (320A, 321B, 322B, 321C, 322C), in order to protect the rest of the working layer (52).

8. Process according to one of the preceding claims, **characterized in that** it also comprises a step of annealing under a reductive atmosphere (102D) after the polishing step (200, 200A, 200B, 200C, 200D).

9. Process according to one of the preceding claims, **characterized in that** it comprises a step of implanting atoms under one face of a wafer, in an implantation zone, a step of placing the face of the wafer, which has undergone the implantation, in intimate contact with a support substrate, and a step of cleaving the wafer in the implantation zone, in order to transfer some of the wafer onto the support substrate and form a thin film or a thin layer thereon, this thin film or this thin layer constituting the working layer (52) which is then subjected to the steps of annealing under a reductive atmosphere (100, 100A, 100B, 100C, 101D, 102D) and of polishing (200, 200A, 200B, 200C, 200D).

10. Process according to one of the preceding claims, **characterized in that** the working layer (52) consists of a semiconductor.

11. Process according to Claim 10, **characterized in that** the semiconductor is silicon.

12. Process according to one of the preceding claims, **characterized in that** the reductive atmosphere comprises hydrogen.

13. Process according to one of the preceding claims, **characterized in that** the reductive atmosphere comprises argon.

## Patentansprüche

1. Verfahren zur Bearbeitung von Substraten (50) für die Mikroelektronik oder die Optoelektronik, die auf wenigstens einer ihrer Flächen eine Nutzschicht (52) haben, die dafür vorgesehen ist, dass in ihr Bauelemente gebildet werden, wobei das Verfahren eine Phase des mechanisch-chemischen Polierens auf der freien Oberfläche (54) der Nutzschicht (52) umfasst, **dadurch gekennzeichnet, dass** es außerdem vor der Polierphase (200, 200A, 200B, 200C, 200D) eine Phase des Temperns in reduzierender Atmosphäre (100, 100A, 100B, 100C, 101D, 102D) umfasst.

2. Verfahren nach Anspruch 1, **dadurch gekennzeichnet, dass** die Temperphase in reduzierender Atmosphäre in weniger als drei Minuten ausgeführt wird, vorzugsweise in weniger als sechzig Sekunden und noch bevorzugter in weniger als dreißig Sekunden.

3. Verfahren nach einem der vorhergehenden Ansprüche, **dadurch gekennzeichnet, dass** die Temperphase in reduzierender Atmosphäre bei einer Temperatur ausgeführt wird, die zwischen 1100°C und 1300°C und vorzugsweise zwischen 1200°C und 1230°C liegt.

4. Verfahren nach einem der vorhergehenden Ansprüche, **dadurch gekennzeichnet, dass** es außerdem nach der Polierphase (200, 200A, 200B, 200C, 200D) eine Phase (310A, 312B, 312C) der Oxidation der Nutzschicht (52) auf wenigstens einem Teil ihrer Dicke umfasst.

5. Verfahren nach einem der vorhergehenden Ansprüche, **dadurch gekennzeichnet, dass** es außerdem vor der Polierphase (200, 200A, 200B, 200C, 200D) eine Phase (311B, 311C) der Oxidation der Nutzschicht (52) auf wenigstens einem Teil ihrer Dicke umfasst.

6. Verfahren nach einem der Ansprüche 4 und 5, **dadurch gekennzeichnet, dass** es außerdem wenigstens eine Phase (330A, 331B, 332B, 331C, 332C) zum Entfernen des Oxids umfasst, das in der Oxidationsphase erzeugt wurde.

7. Verfahren nach einem der Ansprüche 4 bis 6, **dadurch gekennzeichnet, dass** es außerdem wenigstens eine Phase der thermischen Behandlung (320A, 321B, 322B, 321C, 322C) umfasst, wobei die Phase der Oxidation der Nutzschicht (52) vor dem Ende jeder Phase zur thermischen Behandlung (320A, 321B, 322B, 321C, 322C) ausgeführt wird, um den Rest der Nutzschicht (52) zu schützen.

8. Verfahren nach einem der vorhergehenden Ansprüche, **dadurch gekennzeichnet, dass** es außerdem eine Phase des Temperns in reduzierender Atmosphäre (102D) umfasst, und dies nach der Polierphase (200, 200A, 200B, 200C, 200D).

9. Verfahren nach einem der vorhergehenden Ansprüche, **dadurch gekennzeichnet, dass** es Folgendes umfasst: eine Phase der Implantation von Atomen unter einer Fläche einer Platte in einer Implantationszone, eine Phase des Herstellens eines engen Kontakts der Plattenfläche, die der Implantation ausgesetzt war, mit einem Trägersubstrat, und eine Phase der Spaltung der Platte im Bereich der Implantationszone, um einen Teil der Platte auf das Trägersubstrat zu übertragen und auf dieser einen dünnen Film oder eine dünne Schicht zu bilden, wobei dieser dünne Film oder diese dünne Schicht die Nutzschicht (52) bildet, auf die anschießend die Phase des Temperns in reduzierender Atmosphäre (100, 100A, 100B, 100C, 101D, 102D) und des Polierens (200, 200A, 200B, 200C, 200D) einwirken.

10. Verfahren nach einem der vorhergehenden Ansprüche, **dadurch gekennzeichnet, dass** die Nutzschicht (52) aus einem Halbleiter besteht.

11. Verfahren nach Anspruch 10, **dadurch gekennzeichnet, dass** der Halbleiter Silizium ist.

12. Verfahren nach einem der vorhergehenden Ansprüche, **dadurch gekennzeichnet, dass** die reduzierende Atmosphäre Wasserstoff enthält.

13. Verfahren nach einem der vorhergehenden Ansprüche, **dadurch gekennzeichnet, dass** die reduzierende Atmosphäre Argon enthält.
